# EUROPÄISCHE PATENTSCHRIFT

(11) **EP 0 499 124 B1**
(45) Veröffentlichungstag und Bekanntmachung des Hinweises auf die Patenterteilung: **31.01.1996**
(21) Anmeldenummer: 92101850.3
(22) Anmeldetag: 05.02.1992
(51) Int. Cl.: C23C 14/28, C23C 14/56, C23C 14/24

(54) **Reihenverdampfer**
Line evaporator
Evaporateur en ligne

(30) Priorität: 14.02.1991 DE 4104415
(43) Veröffentlichungstag der Anmeldung: 19.08.1992
(73) Patentinhaber: 4P Verpackungen Ronsberg GmbH, D-87671 Ronsberg (DE); Weinert, Hilmar, Dipl.-Ing., D-87600 Kaufbeuren (DE)
(72) Erfinder: Hilmar, Weinert, Dipl.-Ing., W-8950 Kaufbeuren 2 (DE)
(74) Vertreter: Hutzelmann, Gerhard

(56) Entgegenhaltungen:
- DE-A- 2 426 687
- DE-A- 2 612 424
- DE-C- 862 991
- US-A- 2 440 135
- US-A- 3 446 936
- PATENT ABSTRACTS OF JAPAN vol. 8, no. 134 (C-230) (1571) 21. Juni 1984 & JP-A-59 043 876 (KONISHIROKU SHASHIN) 12. März 1984
- PATENT ABSTRACTS OF JAPAN vol. 14, no. 342 (C-743) (4285) 24. Juli 1990 & JP-A-02 125 866 (KOBE STEEL) 14. Mai 1990

## Beschreibung

Die Erfindung bezieht sich auf einen Reihenverdampfer mit allseitiger thermischer Isolierung, Strahlungsheizern und Strahlungsabschirmungen, die eine Anzahl von Dampfaustrittsöffnungen in Richtung auf ein zu beschichtendes Substrat aufweisen.

Aus der CH-PS 255 422 ist eine durchgehende Verdampferdüse bekannt, die sich quer zur Laufrichtung der zu beschichtenden Bahn erstreckt und durch Zwischenstücke unterteilt ist.

Bei diesem bekannten Verdampfer ist nur der Einsatz von flüssigem Material möglich, das durch einen rohrförmigen Heizstab auf Verdampfungstemperatur gebracht wird. Dieser Heizstab ist genau unterhalb der Austrittsdüse angeordnet.

Die DE-PS 976 068 beschreibt darüber hinaus ein Verfahren und eine Einrichtung zum Bedampfen eines laufenden Substrates, wobei eine Düse zum scharf gerichteten Austreten eines Dampfstrahles vorgesehen ist.

Darüber hinaus ist aus der DE-PS 970 246 eine Vorrichtung zum laufenden Bedampfen endloser Gebilde bekannt, die mit mehreren schlitzförmigen Ausnehmungen zum Austreten der dampfförmigen Beschichtungsmasse versehen ist.

Von diesem Stand der Technik ausgehend liegt der Erfindung die Aufgabe zugrunde, das zu bedampfende Substrat weitgehend gegen eine vom Verdampfer ausgehende Wärmestrahlung abzuschirmen und das Substrat gleichmäßig und rationell zu beschichten, wobei eine Beschädigung des Substrates vermieden werden soll.

Diese Aufgabe wird erfindungsgemäß dadurch gelöst, daß die Strahlungsheizer weitgehend eben ausgebildet und jeweils unterhalb einer oberen Strahlungsabschirmung und innerhalb von deren Abdeckbereich angeordnet sind und parallel zur Oberfläche des zu verdampfenden Materials verlaufen, und daß die auf das zu bedampfende Material gerichteten Austrittsöffnungen zwischen den Strahlungsheizern vorgesehen sind.

Dadurch wird eine gleichmäßige Beheizung der gesamten Oberfläche des zu verdampfenden Materials und damit eine sehr effektive Verdampfung erreicht; darüber hinaus wird vermieden, daß aufgrund der Heizstrahlung aus dem Material herausspritzende Partikel durch die Austrittsöffnungen auf das zu beschichtende Substrat gelangen und dort Beschädigungen hervorrufen.

Sehr vorteilhaft ist es, wenn gemäß der Erfindung das zu verdampfende Material eine im Hochvakuum durch Sublimation verdampfende Substanz, wie z.B. Siliziummonoxid, Magnesiumoxid, Gemische von Metallen und deren Oxiden, oder Chrom-Metall ist.

Eine vorteilhafte Ausgestaltung der Erfindung liegt auch darin, daß Tiegel aus hochschmelzendem Metall, Bornitrid, Titanborid oder deren gesinterten Mischungen, Aluminiumoxid, Magnesiumoxid, Berylliumoxid zur Aufnahme von flüssigen Metallen vorgesehen sind, wodurch diese aus ihrer flüssigen Phase verdampft werden können.

Weiterhin sehr vorteilhaft ist es, wenn erfindungsgemäß in dem das zu verdampfende Material aufnehmenden Teil des Verdampfers eine Trennwand eingesetzt ist, durch welche zwei Räume zur gleichzeitigen Verdampfung von zwei sublimierenden Materialien von ähnlich großem Dampfdruck geschaffen sind, wobei sich diese beiden Materialien erst in der Dampfphase mischen.

Damit ist ein sehr rationelles Verfahren zum Beschichten mit mehreren Materialien geschaffen.

Sehr vorteilhaft ist es dabei auch, wenn erfindungsgemäß zwei Tiegelrinnen oder zwei Paare von Einzeltiegeln vorgesehen sind, welche zur Aufnahme von zwei flüssigen Materialien von ähnlich großem Dampfdruck und deren gleichzeitigem Verdampfen vorgesehen sind, wobei sich diese Materialien erst in der Dampfphase mischen.

Als sehr vorteilhaft hat es sich auch erwiesen, wenn gemäß der Erfindung die Strahlungsheizer aus Wolfram, Tantal oder Molybdän bestehen.

Sehr günstig ist es auch, wenn erfindungsgemäß die Strahlungsheizer in Form von Blechen, Drahtnetzen, bzw. flächig angeordneten parallelen Stäben oder Drähten ausgebildet sind.

Die thermische Isolierung sowohl des Trägerkastens als auch der oberen Abschirmbleche ist bei einer vorteilhaften Ausgestaltung der Erfindung aus mehreren Einzelblechen aus Molybdän, Wolfram oder Tantal mit einer Stärke von unter einem Millimeter pro Einzelblech aufgebaut.

Erfindungsgemäß kann die thermische Isolierung des Trägerkastens und der oberen Abschirmbleche aber auch aus Graphit, Aluminiumoxid, Zirkonoxid, Bornitrid/Titanborid-Sintergemischen bestehen, mit einer Dicke pro Lage von 1 bis 4 mm.

In der Zeichnung ist die Erfindung anhand zweier Ausführungsbeispiele veranschaulicht. Dabei zeigen:
- Fig.1a: einen Vertikalschnitt durch einen Reihenverdampfer, nach Linie A-A in Fig.1b
- Fig.1b: eine Draufsicht auf den Reihenverdampfer
- Fig.1c: eine Längsschnitt durch den Reihenverdampfer nach Linie B-B in Fig.1b
- Fig.2: eine schematische Darstellung einer Beschichtungseinrichtung im Längsschnitt und
- Fig.3a,b: eine Schnittdarstellung bzw. eine Ansicht eines weiteren Reihenverdampfers, der durch eine Trennwand unterteilt ist.

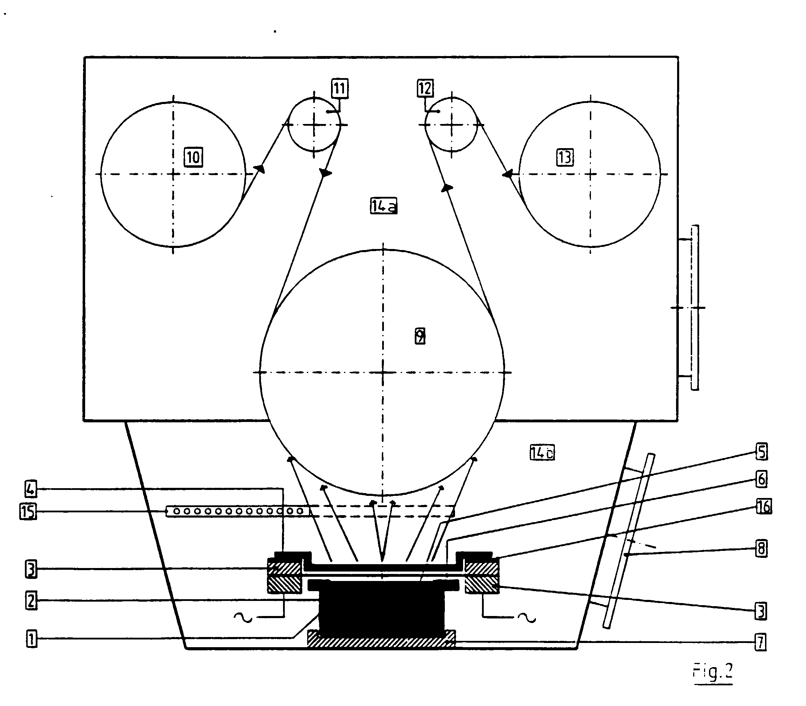

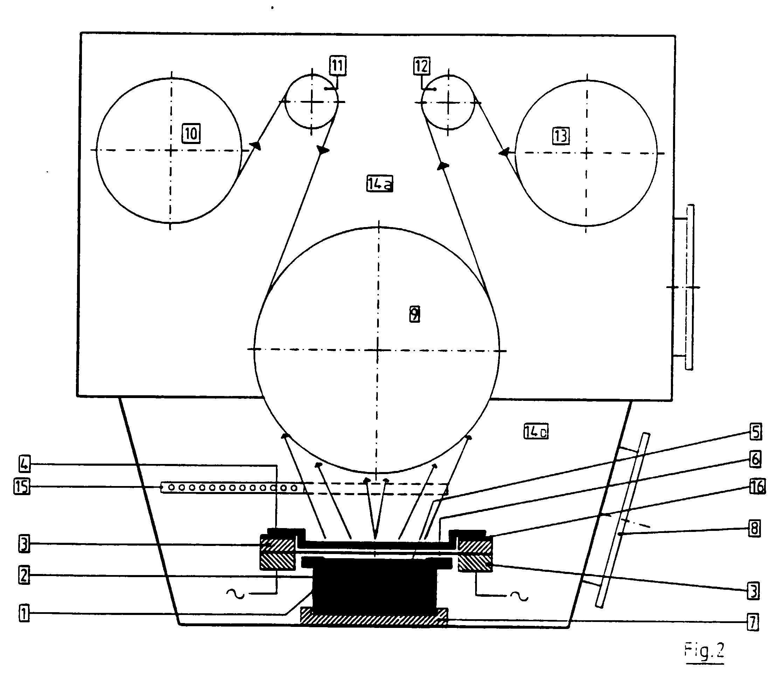

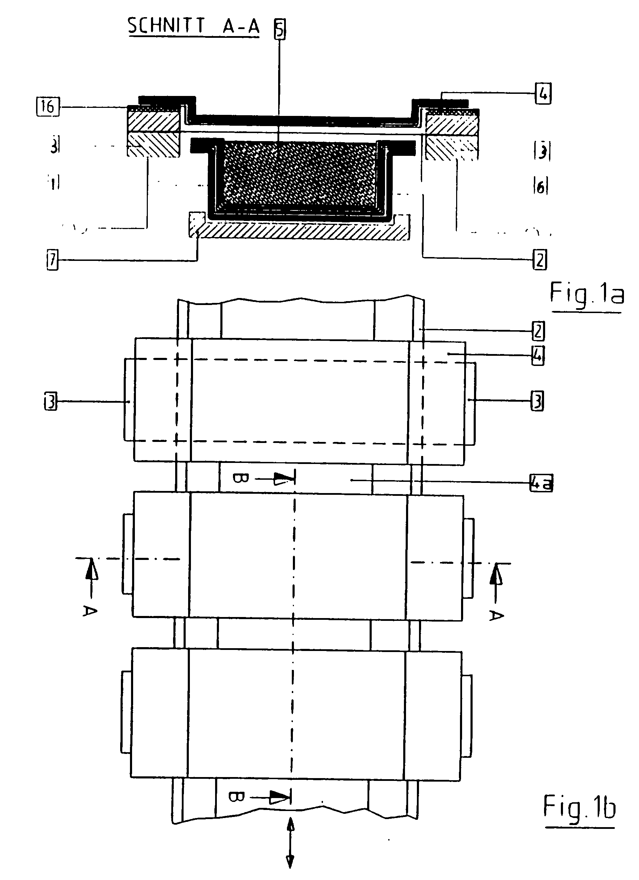

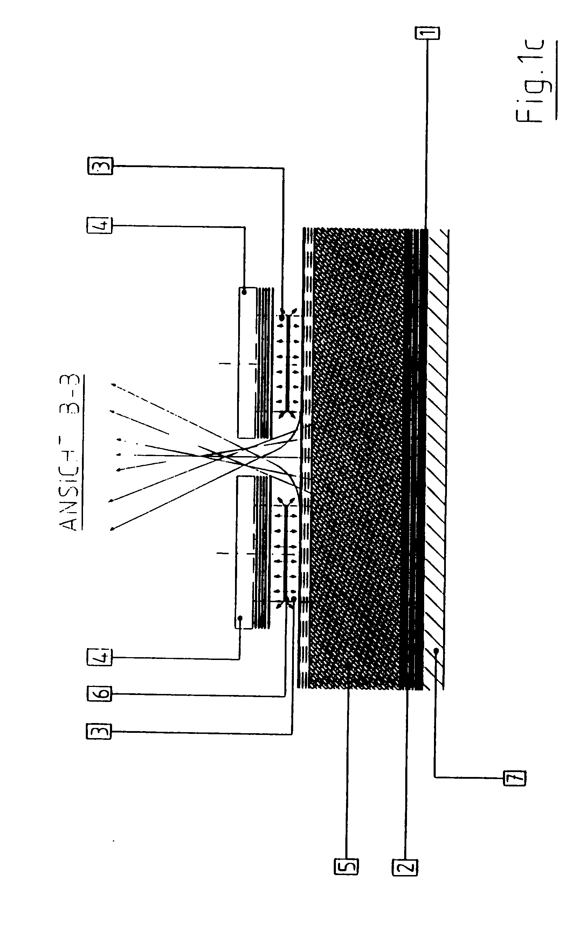

In den Figuren 1a,1b,1c ist ein Reihenverdampfer dargestellt, der einen Trägerkasten 1 sowie mehrere Strahlenbleche 2 aufweist. Mit 3 sind Einspannblöcke bezeichnet, in welche die eigentlichen Heizer 6 eingespannt sind. Oberhalb dieser Einspannblöcke 3 bzw. der Heizer 6 sind mehrlagige Abdeckbleche 4 angeordnet, zwischen denen Austrittsöffnungen 4a vorgesehen sind. Diese Austrittsöffnungen 4a haben eine Weite von 7 bis 10 mm und nehmen damit etwa 5 % der der zu beschichtenden Folie zugewandten Fläche und nur 1,5 % der gesamten Außenfläche des Reihenverdampfers ein. Für den Austritt des Dampfes sind elf derartige, spaltenförmig ausgebildete Austrittsöffnungen 4a vorgesehen, die voneinander einen Abstand von 148 mm aufweisen. Zwischen keinem der Heizer 6 und der Folie besteht eine geradlinige Sichtverbindung. Nur das um etwa 500 °C kältere zu verdampfende Material 5 besitzt eine Sichtverbindung zur Folie und trägt mit einem geringen Teil zur Wärmeabstrahlung bei. Eventuell überhitzte Siliziummonoxidpartikel können nur direkt unterhalb des Heizers 6 entstehen. Ihre Flugrichtung zur Folie hin ist auf direktem Weg nicht möglich. Bei einem Aufprall auf irgendeiner der Innenflächen des Reihenverdampfers werden diese Partikel so reflektiert, daß sie immer nocht nicht aus den spaltförmigen Austrittsöffnungen 4a austreten können. Erst nach einem zweiten Aufprall könnten solche Partikel theoretisch in Richtung auf die Folie austreten. Dies ist nicht der Fall, da die Partikel dann bereits ihre kinetische Energie weitgehend verloren haben.

Durch diese Maßnahmen wird ein Verdampfer geschaffen, welcher bei den gewünschten Schichtdicken von 70 bis 120 Nanometer die thermische Belastung der zu bedampfenden Folien wesentlich reduziert, welcher Siliziummonoxid auch als loses Schüttgut verdampfen kann und welcher die schädliche Spritzerbildung durch heiße Partikel verhindert. Durch eine geeignete Wahl der geometrischen Verhältnisse, nämlich des Abstandes der spaltförmigen Austrittsöffnungen 4a zum Abstand dieser zur Folie entsteht eine bis zu +/- 5 Prozent gleiche Verteilung der Schichtdicke quer zur Bahnrichtung. Da jeder Heizer 6 seine eigene Energiequelle besitzt, besteht durch Veränderung einzelner Heizleistungen eine weitere Möglichkeit zur Beeinflussung der Schichtdickenverteilung.

Anhand der im Folgenden beschriebene Reihenverdampfer wird die Durchführung von Bedampfungen mit Siliziummonoxid, aber auch von anderen Materialien und Gemischen davon mit ähnlichem Dampfdruck auf Kunststoff-Folien, Papier oder Metallbändern erläutert.

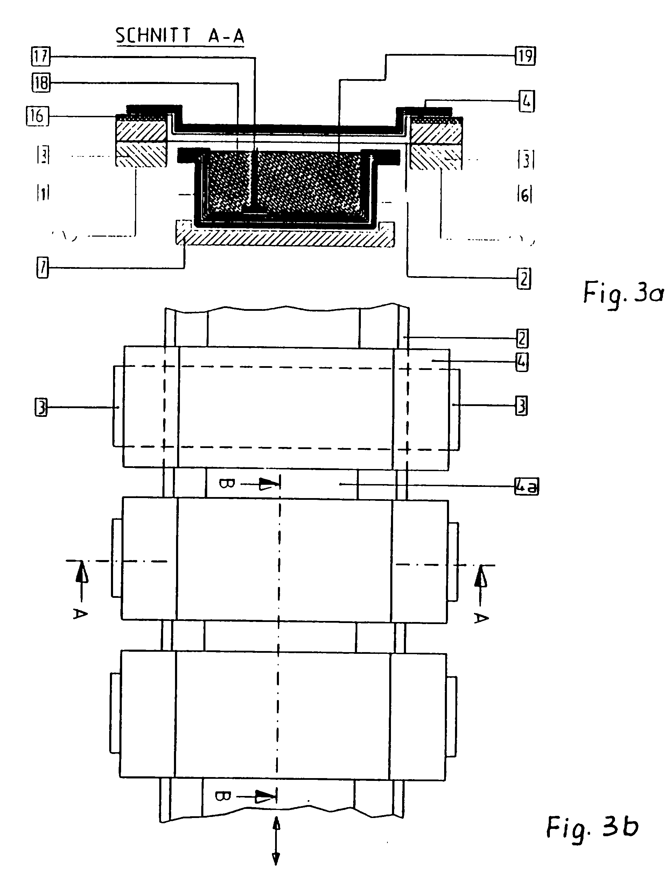

Nach Fig. 2 befindet,sich der Reihenverdampfer in einem Abstand von ca. 150 bis 300 mm unterhalb einer Kühlwalze 9. Dazwischen befindet sich eine wassergekühlte Blende 15, welche erst nach Erreichen einer minimalen Wickelgeschwindigkeit geöffnet wird. Diese geometrische Anordnung entspricht soweit der einer klassischen Bedampfungsanlage, mit Abwickler 10, Leitwalzen 11, 12, Aufwickler 13, Wickelkammer 14a, Aufdampfkammer 14b. Der Reihenverdampfer besteht aus in Abständen von 80 bis 200 mm befindlichen Heizer-Einspannblöcken 3, zwischen welchen je ein Heizer 6, welcher aus einem Blech aus Molybdän, Tantal oder Wolfram bestehen kann, aber auch aus parallelen Stäben oder einem Drahtgitter aus denselben Materialien bestehen kann. Diese Heizer 6 werden im direkten Stromdurchgang über je eine stufenlos regelbare Stromversorgung geregelt, um die Heizertemperaturen quer zur Bahnrichtung der zu bedampfenden Folie und damit auch die Verdampfungsgeschwindigkeit einzeln regeln zu können. Die Heizer 6 befinden sich nicht im Kontakt mit dem zu verdampfenden Material 5, vorzugsweise Siliziummonoxid, um chemische Reaktionen zwischen dem Heizermaterial und dem zu verdampfenden Material 5 zu vermeiden. Die Einbringung der thermischen Energie in das zu verdampfende Material 5 erfolgt über Wärmestrahlung.

Der wesentliche Bestandteil der Erfindung ist die Abschirmung der Heizerstrahlung in Richtung auf die zu bedampfende Folie und die Unterbindung der direkten Sicht von den Heizern 6 auf die Folie zum Zwecke der Unterdrückung der von den Heizern ausgehenden Wärmestrahlung und zum Zwecke der Verhinderung des Ausschleuderns von Partikeln von Verdampfermaterial. Diese mehrlagigen Abdeckungen 4 sind breiter als die Heizer 6 ausgelegt, um diese beiden Forderungen zu erfüllen.

Diese mehrlagigen Abdeckungen 4 befinden sich wenige Zentimeter oberhalb der Heizer 6. Sie liegen auf den Heizer-Einspannblöcken 3 lose auf unter Zwischenlage einer Isolatorplatte 16 und bestehen aus einem Material, welches über einen, der notwendigen Heizertemperatur entsprechenden vernachlässigbaren geringen Dampfdruck verfügt und deshalb nicht selbst abdampft. Geeignete Materialien, in 2- bis 10-facher Lage sind dünne Molybdän-, Tantal- oder Wolframbleche. Nach den Gesetzen der Wärmeübertragung (Gröber/Erk/Grigull: Wärmeübertragung, S. 390-392) vermindern parallele Zwischenlagen, die zwischen einem heißen, planen Objekt, hier der Heizer 6 und einer kalten Wand, hier die zu bedampfende Folie, eingebracht werden, die Wärmestrahlung nach der Beziehnung:
- Q = Q₀(n + 1) Q₀:: Strahlung ohne Abschirmung (W/m)
- Q:: Strahlung bei n Zwischenlagen (W/m)
- n:: Zahl der Zwischenlagen

Die Zahl der Zwischenlagen ist aus praktischen Gründen auf etwa zehn begrenzt. Ferner sind die mehrlagigen Abdeckungen 4 so auszuführen, daß die Austrittsöffnungen 4a für den Dampf so klein wie möglich gehalten werden, damit über diese selbst möglichst wenig Wärmestrahlung austreten kann.

Typische Heizertemperaturen für eine ausreichend hohe Verdampfungsgeschwindigkeit liegen im Falle von Siliziummonoxid bei ca. 1750°C, wobei das zu verdampfende Material 5 eine Oberflächentemperatur von ewtwa 1250°C annimmt.

Im Falle der Verdampfung vcon Siliziummonoxid ist ferner zu beachten, daß bei Überhitzung des Materials auf über 1300°C eine thermische Zersetzung auftritt. Bei zu kleinen Austrittsöffnungen ist zwar die Wärmebelastung der Folie durch Strahlung wünschenswert gering, jedoch muß das zu verdampfende Material 5 wesentlich höher erhitzt werden, um bei der geforderten Abdampfmenge von ca. 3 kg pro Stunde und pro Meter Arbeitsbreite einen entsprechenden höheren Dampfdruck zu erzeugen. Bei zu großen Austrittsöffnungen leistet die Wärmestrahlung, die von dem zu verdampfenden Material 5 ausgeht, einen zu hohen Beitrag zur Wärmebelastung der Folie.

Durch Computerprogramme vorberechnete Optimierungen konnten in der Praxis mit guter Näherung bestätigt werden:
- Beispiel:: 12-fach Reihenverdampfer für 1600mm Arbeitsbreite Heizer: 12 x 220 mm x 70 mm, Molybdänblech Temperatur des Verdampfungsmaterial: 1250°C Temperatur der Heizer: 1700°C Verdampfungsgeschwindigkeit für Siliziummonoxid: 12 x 6 g/min

Über die Temperaturdifferenz zwischen dem Kühlwassereintritt und -austritt an der geschlossenen Blende 15 (Fig.2) wurde bei gleicher Verdampfungsgeschwindigkeit festgestellt:

| Strahlung(kW) Kondensationswärme(kW) | | |
|---|---|---|
| 1) Heizer 6 ohne Abschirmung 4 (frei abstrahlend) Abschirmung n-lagig (Mo-Blech, Emissionsfaktor 0.3) Fläche der Austrittsöffnungen/Fläche der Abschirmung (=f) | 138 | 15.0 |
| 2) n= 4, f= 0.1 | 25.9 | 15.0 |
| 3) n= 6, f= 0.1 | 17.3 | 15.0 |
| 4) n= 6, f=0 (theoretisch Abschirmung ohne Öffnungen) | 6.2 | |
| 5) n= 6, f= 0.05 | 14.6 | 15.0 |

Gemessene Temperatur der 6.Lage der Abschirmung bei 1250°C Verdampfungstermperatur und 1700°C Heizertemperatur: 666°C

Eine weitere Verkleinerung der Austrittsöffnungen ist ungünstig. Diese wirken dann bereits als ein Strömungshindernis für den Dampf. Ein Ausgleich ist dann nur möglich durch Erhöhung der Verdampfungstemperatur, welche die erzielbare Verbesserung wieder zunichte macht.

Es zeigt sich, daß sich die Wärmebelastung gegenüber einem unabgeschirmten Verdampfer um 80% verringert, wenn man die Fälle 1) und 5) vergleicht. Es können daher gegenüber bekannten Verfahren, bei gleicher thermischer Belastung der Folie über 5 mal so hohe Schichtdicken aufgedampft werden. Ein weiterer Vorteil ist, daß es hierdurch möglich wurde, auch solche Folienmaterialien, die gegenüber dem normalerweise verwendeten Polyester nur eine geringere thermische Belastung zulassen, mit einer ausreichenden Gasbarriere erzeugenden Schichten zu bedampfen. Solche Materialien sind: Polypropylenfolien, OPA-Folien, Polyaethylenfolien, aber auch lackierte Papiere.

Der Gesamtaufbau des Reihenverdampfers besteht aus:

Einem Trägerkasten 1 aus hitzebeständigem Stahl, welcher auf einer Unterlage 7 zum Beladen oder Wechseln unterhalb der Heizer 6 zwischen den Heizereinspannblöcken 3, ohne Demontage der Heizer 6 und Abnehmen der mehrlagigen Abdeckungen 4 in horizontaler Richtung bei geöffneter Bedampfungsanlage ausziehbar ist. Dieser Trägerkasten selbst ist mit mehrlagigen Abdeckblechen 2 nach außen thermisch isoliert. An diese, die Strahlung abhaltenden Abdeckbleche 2 werden dieselben Anforderungen gestellt wie an die mehrlagigen Abdeckbleche 4. Zusätzlich müssen diese der Forderung gerecht werden, mit dem zu verdampfenden Material 5, welches sich mit ihnen unten und an den Seiten in Kontakt befindet, keine chemische Reaktionen einzugehen. Hierzu eignen sich Bleche aus Molybdän, Tantal oder Wolfram. Der Reihenverdampfer weist wegen seiner allseitigen thermischen Isolierung, die nur durch die Austrittsöffnungen 4a für den Dampf unterbrochen ist, einen um ca. 70 % geringeren Energieverbrauch als ein klassischer Verdampfer. Als weiterer Vorteil erweist sich, daß die beim Verdampfen von Siliziummonoxid gefürchtete Spritzerbildung bei dieser Anordnung nicht auftritt. Diese Spritzerbildung entsteht dadurch, daß sich unterhalb der Oberfläche dieses spröden Materials bei Überhitzung ein so hoher Dampfdruck bilden kann, daß einzelne, etwa 0.01 bis 0.1 mm große Partikel abplatzen und aus dem Verdampfer ausgeschleudert werden. Durch die Geometrie der Austrittsöffnungen 4a und der Heizer 6 ist ein solches Ausschleudern von Partikeln nicht mehr möglich.

Die Erfindung bezieht sich nicht nur auf die Verdampfung von Siliziummonoxid, bzw. auf Gemische von Silizium und Siliziumdioxid. Aufgrund der guten Abschirmung des Reihenverdampfers und seines wirksamen Schutzes gegen Spritzerbildung lassen sich mit Erfolg bei etwas geringeren Verdampfungsgeschwindigkeiten, aber ohne eine thermische Überlastung der zu bedampfenden Folien, Schichten aus verdampftem Titanmonoxid, Magnesiumoxid, unzersetzt verdampfbaren Silikaten erzeugen. Diese Stoffe, wie auch die meisten Metalle, außer Chrom verdampfen aus einer flüssigen Phase. Zur Verdampfung dieser Stoffe wird hierzu in den hier beschriebenen Reihenverdampfer ein gemeinsamer Tiegel oder mehrere Tiegel aus einem geeigneten Material, z.B. Tantal, Wolfram, Zirkonoxid, Aluminiumoxid, Bornitrid oder -unter Anwendung vorgeschriebener Vorsichtsmaßnahmenauch Tiegel aus Berylliumoxid eingesetzt.

Bei auf 10 Abschirmlagen erweiterten Isolierungen der mehrlagigen Abdeckbleche 4 und der Isolierung (Abdeckbleche 2) im Trägerkasten sind Heizertemperaturen bis 2400°C möglich. Bei 10-lagiger Isolierung mit Wolfram- und Molybdänblechen beträgt die Temperatur der äußersten Lage 1195°C. Die abgestrahlte Leistung beträgt ca. 47 kW/m oder typisch 16.5 kW für einen 1600 mm breiten Reihenverdampfer. Kupfer, Gold, Silber, Nickel, Chrom, auch Zink und Aluminium können verdampft werden.

Eine weitere Ausführungsform des Reihenverdampfers zeigt Fig.3:

Durch Einbau einer Trennwand 17 aus hitzebeständigem Material, welches auch ein Keramikmaterial sein kann, wie z.B. Aluminiumoxid, Magnesiumoxid, Bornitrid oder Titandiborid kann der Reihenverdampfer zur gleichzeitigen Verdampfung von zwei Materialien benutzt werden, wobei die einzelnen Komponenten sich erst in der Dampfphase mischen. Voraussetzung hierzu ist, daß die Dampfdrücke beider Komponenten sich nicht um mehr als einen Faktor 2 bis 3 unterscheiden. Durch die Aufteilung des Innenraums in einen Raum 18 und einen Raum 19 läßt sich die pro Zeiteinheit verdampfte Menge der Komponente A und der Komponente B beeinflussen. Da der Innenraum nach außen bis auf die Austrittsöffnungen 4a, die nur wenige Prozent der gesamten Oberfläche des Innenraums betragen, sehr wirksam thermisch isoliert ist, kann in beiden Räumen 18 und 19 von einer gleichen Temperatur ausgegangen werden. Die aus Raum 18 und Raum 19 pro Zeiteinheit abgedampften Massen verhalten sich bei Materialien mit ähnlichem Emmissionszahlen annähernd wie:
- m1/m2 =: (F1 x p1 x o1) / (F2 x p2 x o2)
- m:: Masse (g)
- F:: Oberfläche eines mit Verdampfungsmaterial gefüllten Raumes
- p:: Dampfdruck jeder Komponente bei der vorliegenden gemeinsamen Temperatur

Versuche haben eine Reproduzierbarkeit von +/- 10% der Zusammensetzung der so erzeugten Mischschicht bestätigt. Solche Mischschichten können sein:
Siliziummonoxid - Chrom
Siliziummonoxid - Aluminium
Kupfer - Aluminium
Nickel - Chrom
Nickel - Kupfer
Silber - Kupfer

Bei Metallen, wie Kupfer, Nickel, Silber, die aus der flüssigen Phase verdampfen, sind statt einer Trennwand geeignete rinnenförmige Tiegel aus Oxidmaterial, Bornitrid oder Tantal zu verwenden. Da die Emissionszahl von Metallen bei Verdampfungstemperatur um einen Faktor 2 bis 4 geringer ist als die von Siliziummonoxid oder anderer elektrisch nichtleitenden Materialien, sind wegen der daraus folgenden geringeren Wärmeübertragung durch die Strahlungsheizung wesentlich höhere Heizertemperaturen notwendig. Es können damit industriell brauchbare Verdampfungsraten erzeugt werden.

## Patentansprüche

1. Reihenverdampfer mit allseitiger thermischer Isolierung, Strahlungsheizern und Strahlungsabschirmungen, die eine Anzahl von Dampfaustrittsöffnungen in Richtung auf ein zu beschichtendes Substrat aufweisen, **dadurch gekennzeichnet,** daß die Strahlungsheizer weitgehend eben ausgebildet und jeweils unterhalb einer oberen Strahlungsabschirmung und innerhalb von deren Abdeckbereich angeordnet sind und parallel zur Oberfläche des zu verdampfenden Materials verlaufen, und daß die auf das zu bedampfende Material gerichteten Austrittsöffnungen zwischen den Strahlungsheizern vorgesehen sind.

2. Reihenverdampfer nach Anspruch 1, **dadurch gekennzeichnet,** daß das zu verdampfende Material eine im Hochvakuum durch Sublimation verdampfende Substanz, wie z.B. Siliziummonoxid, Magnesiumoxid, Gemische von Metallen und deren Oxiden, oder Chrom-Metall ist.

3. Reihenverdampfer nach Anspruch 1, **dadurch gekennzeichnet,** daß Tiegel aus hochschmelzendem Metall, Bornitrid, Titanborid oder deren gesinterten Mischungen, Aluminiumoxid, Magnesiumoxid, Berylliumoxid zur Aufnahme von flüssigen Metallen vorgesehen sind, wodurch diese aus ihrer flüssigen Phase verdampft werden können.

4. Reihenverdampfer nach Anspruch 1 oder 2, **dadurch gekennzeichnet,** daß in dem das zu verdampfende Material aufnehmenden Teil des Verdampfers eine Trennwand eingesetzt ist, durch welche zwei Räume zur gleichzeitigen Verdampfung von zwei sublimierenden Materialien von ähnlich großem Dampfdruck geschaffen sind, wobei sich diese beiden Materialien erst in der Dampfphase mischen.

5. Reihenverdampfer nach Anspruch 1 oder 3, **dadurch gekennzeichnet,** daß zwei Tiegelrinnen oder zwei Paare von Einzeltiegeln vorgesehen sind, welche zur Aufnahme von zwei flüssigen Materialien von ähnlich großem Dampfdruck und deren gleichzeitigem Verdampfen vorgesehen sind, wobei sich diese Materialien erst in der Dampfphase mischen.

6. Reihenverdampfer nach einem der vorhergehenden Ansprüche, **dadurch gekennzeichnet,** daß die Strahlungsheizer aus Wolfram, Tantal oder Molybdän bestehen.

7. Reihenverdampfer nach einem der vorhergehenden Ansprüche, **dadurch gekennzeichnet,** daß die Strahlungsheizer in Form von Blechen, Drahtnetzen, bzw. flächig angeordneten parallelen Stäben oder Drähten ausgebildet sind.

8. Reihenverdampfer nach einem der vorhergehenden Ansprüche, **dadurch gekennzeichnet,** daß die thermische Isolierung sowohl des Trägerkastens als auch der oberen Abschirmbleche aus mehreren Einzelblechen aus Molybdän, Wolfram oder Tantal mit einer Stärke von unter einem Millimeter pro Einzelblech aufgebaut ist.

9. Reihenverdampfer nach einem der Ansprüche 1 bis 7, **dadurch gekennzeichnet,** daß die thermische Isolierung des Trägerkastens und der oberen Abschirmbleche aus Graphit, Aluminiumoxid, Zirkonoxid, Bornitrid/Titanborid-Sintergemischen besteht, mit einer Dicke pro Lage von 1 bis 4 mm.

## Claims

1. Series evaporator with thermal insulation on all sides, radiant heaters and heat shields that have a number of vapour outlet openings facing a substrate that is to be coated, **wherein** the radiant heaters are essentially flat, are each located underneath an upper heat shield and within the area protected by the shield concerned, and run parallel to the surface of the material that is to be evaporated, and **wherein** the outlet openings directed towards the material that is to be coated are provided between the radiant heaters.

2. Series evaporator according to claim 1, **wherein** the material that is to be evaporated is a substance that evaporates by sublimation in a high vacuum, such as silicon monoxide, magnesium oxide, mixtures of metals and their oxides or chromium metal.

3. Series evaporator according to claim 1, **wherein** vessels made from metal with a high melting point, boron nitride, titanium boride or sintered mixtures of them, aluminium oxide, magnesium oxide or beryllium oxide are provided to hold liquid metals, so that these metals can be evaporated from their liquid phase.

4. Series evaporator according to claim 1 or 2, **wherein** a partition wall is fitted in the section of the evaporator holding the material that is to be evaporated, thus creating two compartments for the simultaneous evaporation of two sublimating materials with similar vapour pressure levels, these two materials not mixing until they are both in the vapour phase.

5. Series evaporator according to claim 1 or 3, **wherein** vessels with two channels or pairs of individual vessels are provided to hold two liquid materials with similar vapour pressure levels for simultaneous evaporation, while these materials only mix in the vapour phase.

6. Series evaporator according to one of the previous claims, **wherein** the radiant heaters are made from tungsten, tantalum or molybdenum.

7. Series evaporator according to one of the previous claims, **wherein** the radiant heaters are in the form of plates, wire netting or parallel bars or wires distributed to cover the required area.

8. Series evaporator according to one of the previous claims, **wherein** the thermal insulation of both the evaporator housing and the upper shield plates consists of several individual plates made from molybdenum, tungsten or tantalum, each of which is less than one millimetre thick.

9. Series evaporator according to one of the claims 1 to 7, **wherein** the thermal insulation of the evaporator housing and the upper shield plates is made from graphite, aluminium oxide, zirconium oxide, sintered boron nitride/titanium boride mixtures with a thickness of 1 to 4 mm per layer.

## Revendications

1. Evaporateur série à isolation thermique tous-côtés, chauffeurs à rayonnement et écrans de rayonnement qui présentent un certain nombre d'ouvertures de sortie de vapeur en direction d'un substrat à recouvrir, **caractérisé par le fait** que les chauffeurs à rayonnement sont conçus dans une large mesure à plat et qu'ils sont disposés à chaque fois en dessous d'un écran de rayonnement supérieur et à l'intérieur de leur zone de recouvrement et qu'ils sont montés parallèlement par rapport à la surface du matériau à évaporer et que les ouvertures de sortie dirigées sur le matériau à évaporer sont prévues entre les chauffeurs à rayonnement.

2. Evaporateur série selon revendication 1, **caractérisé par le fait** que le matériau est une substance à évaporer dans un vide très poussé par sublimation, comme par exemple oxyde de silicium, oxyde de magnésium, mélanges de métaux et de leurs oxydes ou métal-chrome.

3. Evaporateur série selon revendication 1, **caractérisé par le fait** que des creusets en métal à point de fusion élevé, du nitrure de bore, du borure de titane ou leurs mélanges frittés, oxyde d'aluminium, oxyde de magnésium, oxyde de béryllium, sont prévus pour collecter des métaux liquides, ceux-ci pouvant ainsi être évaporés depuis leur phase liquide.

4. Evaporateur série selon la revendication 1 ou 2, **caractérisé par le fait** que la partie de l'évaporateur accueillant le matériau à évaporer, une paroi de séparation est installée, formant deux chambres pour l'évaporation simultanée de deux matériaux sublimants présentant une pression de vapeur de valeur semblable, ces deux matériaux ne se mélangeant que dans la phase de vapeur.

5. Evaporateur série selon revendication 1 ou 3, **caractérisé par le fait** que deux échenaux de creuset ou que deux paires de creusets individuels sont prévus pour la collecte de deux matériaux liquides présentant une pression de vapeur de valeur semblable et pour leur évaporation simultanée, ces matériaux ne se mélangeant que dans la phase de vapeur.

6. Evaporateur série suivant l'une des revendications précédentes, **caractérisé par le fait** que les chauffeurs à rayonnement sont exécutés en tungstène, en tantale ou en molybdène.

7. Evaporateur série suivant l'une des revendications précédentes, **caractérisé par le fait** que les chauffeurs à rayonnement sont exécutés sous forme de tôles, de treillis en fil métallique ou resp. de tiges ou de fils parallèles disposés en surface.

8. Evaporateur série suivant l'une des revendications précédentes, **caractérisé par le fait** que l'isolation thermique aussi bien de la boîte porteuse que des tôles d'écran supérieures est exécutée à partir de plusieurs tôles individuelles en molybdène, en tungstène ou en tantale d'une épaisseur inférieure à un millimètre par tôle individuelle.

9. Evaporateur série suivant l'une des revendications 1 à 7, **caractérisé par le fait** que l'isolation thermique de la boîte porteuse et des tôles d'écran supérieures est réalisée en graphite, en oxyde d'aluminium, en oxyde de zirconium, en mélanges de frittage de nitrure de bore/de borure de titane, avec une épaisseur de 1 à 4 mm par couche.
